# EUROPEAN PATENT APPLICATION

(11) **EP 3 683 269 A1**
(43) Date of publication of application: **22.07.2020**
(21) Application number: 18856180.7
(22) Date of filing: 12.09.2018
(51) Int. Cl.: C08L 63/00, B32B 27/34, B32B 27/38, C08J 5/04, C08L 77/00, C09D 163/00, C09D 177/00, C09J 163/00, C09J 177/00, C09K 3/10, H01L 23/29, H01L 23/31, H05K 1/03

(54) **EPOXY RESIN COMPOSITION**

(30) Priority: 15.09.2017 JP 2017177801
(71) Applicant: Sumitomo Seika Chemicals Co., Ltd., Kako-gun Hyogo 675-0145 (JP)
(72) Inventor: KAKUTAKA, Kairi, Himeji-shi Hyogo 672-8076 (JP); FUKUDA, Noriaki, Osaka-shi Osaka 541-0041 (JP); FUNABIKI, Yuhei, Himeji-shi Hyogo 672-8076 (JP)
(74) Representative: Mewburn Ellis LLP
(86) International application number: PCT/JP2018/033727
(87) International publication number: WO 2019/054392

(57) **Abstract**

There is provided an epoxy resin composition having excellent adhesion to copper and aluminum, and having excellent adhesion in a low-temperature environment. The epoxy resin composition comprises (A) an epoxy resin and (B) a copolymer nylon powder.

## Description

### Technical Field

The present invention relates to an epoxy resin composition.

### Background Art

In the modern society, many products are made by utilizing various characteristics of organic polymers and assemblies thereof, such as electronic materials, electrical devices, chemical industry, paper, construction materials, paints, pharmaceutical products, cosmetic products, sundry goods, and the like. In these products, a size reduction has been constantly required, and there is a problem of how they can be more compact while having more functionality.

Moreover, along with the technological advances, improved properties have been required in these products to meet the purposes of their use, which has led to technological innovations in the fields of electronics, high-performance paints and pavement materials, automobiles, and the like. In the electronics field, for example, there has been an increasing demand for its representative products, namely, semiconductors, and semiconductors used for thin notebook computers, mobile phones, mobile devices, and the like have been demanded to achieve miniaturization, reduction in weight and thickness, higher-density packaging, and higher integration. For these semiconductors, an adhesive or a composite has been needed that can seal joint portions thinly and locally.

Adhesives are demanded to have a strong adhesion force between different types of materials. There is also a high demand for adhesives for interior materials or adhesives for structures, such as for automobiles, aircraft, or vehicles, and adhesives for structures intended for constructions, such as roofs, walls, or floors. In general, epoxy resins are suitable as such adhesives used for a variety of purposes, and many studies have been made on epoxy resins.

It is known that an epoxy resin, which is a thermosetting resin, forms a random network structure when cured, and provides a cured product that is excellent in properties such as mechanical strength, heat resistance, water resistance, adhesion, electrical insulation properties, and chemical resistance.

However, epoxy resins still have problems in terms of toughness, sufficient adhesion to poorly adhesive substrates, adhesion over a wide range of temperatures, and the like. Various studies have been made to overcome the problems of the epoxy resins.

Patent Literature 1, for example, discloses an adhesive for a structure having excellent adhesion force, which is obtained by blending a carboxyl-terminated nitrile butadiene rubber into an epoxy resin.

Patent Literature 2, for example, discloses an epoxy resin composition that exhibits excellent peel strength, which is obtained by blending 12-nylon particles into an epoxy resin.

### Citation List

### Patent Literature

Patent Literature 1: JP H5-148337 A
Patent Literature 2: JP 2005-036095 A

### Summary of Invention

### Technical Problem

While the epoxy resin compositions disclosed in Patent Literatures 1 and 2 exhibit excellent adhesion to iron or steel sheets, they have poor adhesion to aluminum or copper, which is a poorly adhesive substrate, and cannot sufficiently meet the requirement for adhesion between different types of materials demanded by the market.

Moreover, adhesive materials have been used over an increasingly wide range of purposes and regions; however, the epoxy resin composition disclosed in Patent Literature 2 does not have sufficient adhesion in a low-temperature environment, which limits the regions of use.

It is a main object of the present invention to provide an epoxy resin composition having excellent adhesion to copper and aluminum, and having excellent adhesion in a low-temperature environment.

### Solution to Problem

The present inventors conducted extensive research to solve the above-described problem. As a result, they found that an epoxy resin composition comprising (A) an epoxy resin and (B) a copolymer nylon powder has excellent adhesion to copper and aluminum, and has excellent adhesion in a low-temperature environment. The present invention was completed as a result of further research based on these findings.

### Advantageous Effects of Invention

The present invention can provide an epoxy resin composition having excellent adhesion to copper and aluminum, and having excellent adhesion in a low-temperature environment. The epoxy resin composition of the present invention can be suitably used for purposes for which conventional epoxy resin compositions have been used, such as, for example, an adhesive, a material for a structure, a composite material, a carbon fiber composite material, an adhesive for an electronic material, a semiconductor sealing material, a potting material, a substrate material, a lamination material, a coating material, and a paint. In particular, the epoxy resin composition of the present invention can be suitably used as an adhesive suitable for joining an aluminum member or a copper member to another member (such as a member composed of aluminum, copper, iron, stainless steel, or the like).

### Description of Embodiments

An epoxy resin composition of the present invention comprises an epoxy resin and a copolymer nylon powder. The epoxy resin composition of the present invention will be hereinafter described in detail. The epoxy resin is denoted herein as the "epoxy resin (A)", and the copolymer nylon powder is denoted herein as the "copolymer nylon powder (B)".

As used herein, the term "comprising" includes "consisting essentially of" and "consisting of".

### <Epoxy Resin (A) >

The epoxy resin (A) is not specifically limited as long as it is an epoxy resin that has epoxy group(s) and is curable. Examples of the epoxy resin (A) include a monoepoxy compound and a polyvalent epoxy compound. The epoxy resin composition of the present invention may contain a single epoxy resin (A), or two or more epoxy resins (A).

Specific examples of the monoepoxy compound include butyl glycidyl ether, hexyl glycidyl ether, phenyl glycidyl ether, allyl glycidyl ether, p-butylphenyl glycidyl ether, p-xylyl glycidyl ether, glycidyl acetate, glycidyl butyrate, glycidyl hexanoate, and glycidyl benzoate.

Examples of the polyvalent epoxy compound include a bisphenol-type epoxy resin, an epoxy resin obtained by glycidylating a polyhydric phenol compound, a novolac-type epoxy resin, an aliphatic ether-type epoxy resin, an ether ester-type epoxy resin, an ester-type epoxy resin, an amine-type epoxy resin, and a cycloaliphatic epoxy resin.

Specific examples of the bisphenol-type epoxy resin include an epoxy resin obtained by glycidylating a bisphenol, such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A, tetrachlorobisphenol A, or tetrafluorobisphenol A.

Specific examples of the epoxy resin obtained by glycidylating a polyhydric phenol compound include an epoxy resin obtained by glycidylating a dihydric phenol-type compound, such as biphenol, dihydroxynaphthalene, or 9,9-bis(4-hydroxyphenyl)fluorene; an epoxy resin obtained by glycidylating a trisphenol-type compound, such as 1,1,1-tris(4-hydroxyphenyl)methane; and an epoxy resin obtained by glycidylating a tetrakisphenol compound, such as 1,1,2,2-tetrakis(4-hydroxyphenyl)ethane.

Specific examples of the novolac-type epoxy resin include an epoxy resin obtained by glycidylating a novolac compound, such as a phenol novolac-type, cresol novolac-type, bisphenol A novolac-type, brominated phenol novolac-type, or brominated bisphenol A novolac-type novolac compound.

Specific examples of the aliphatic ether-type epoxy resin include an epoxy resin obtained by glycidylating a polyhydric alcohol, such as glycerin or polyethylene glycol.

Specific examples of the ether ester-type epoxy resin include an epoxy resin obtained by glycidylating a hydroxycarboxylic acid, such as p-hydroxybenzoic acid.

Specific examples of the ester-type epoxy resin include an epoxy resin obtained by glycidylating a polycarboxylic acid, such as phthalic acid or terephthalic acid.

Specific examples of the amine-type epoxy resin include an epoxy resin obtained by glycidylating an amine compound, such as 4,4'-diaminodiphenylmethane or m-aminophenol.

Specific examples of the cycloaliphatic epoxy resin include 3,4-epoxycyclohexylmethyl-3',4'-epoxycyclohexane carboxylate, 1,2-epoxy-4-vinylcyclohexane, bis(3,4-epoxycyclohexylmethyl)adipate, 1-epoxyethyl-3,4-epoxycyclohexane, limonen diepoxide, and 3,4-epoxycyclohexylmethanol.

Among the epoxy resins (A), the bisphenol-type epoxy resin is preferred; in particular, a bisphenol A-type epoxy resin or a bisphenol F-type epoxy resin, for example, is suitably used.

### <Copolymer Nylon Powder (B)>

In the present invention, the copolymer nylon powder (B) is composed of the powder of a copolymer nylon.

The copolymer nylon constituting the copolymer nylon powder (B) is not specifically limited as long as it is a copolymer nylon, and may be a known one or one that is produced by a known method. The copolymer nylon may also be a commercially available copolymer nylon. As the copolymer nylon constituting the copolymer nylon powder (B), a single copolymer nylon, or two or more copolymer nylons may be used.

Examples of the copolymer nylon include a copolymer nylon produced by a method such as polycondensation of a diamine and a dicarboxylic acid, polycondensation of an ω-amino-ω'-carboxylic acid, or ring-opening polymerization of a cyclic lactam. Specifically, examples of the copolymer nylon include a copolymer nylon in which a diamine and a dicarboxylic acid have been polycondensed, a copolymer nylon in which an co-amino-co'-carboxylic acid has been polycondensed, and a copolymer nylon in which a cyclic lactam has been ring-opened. In the polycondensation or ring-opening polymerization, a dicarboxylic acid or a monocarboxylic acid may be used as a polymerization regulator.

The copolymer nylon in which a diamine and a dicarboxylic acid have been polycondensed is, in other words, a copolymer nylon containing a diamine and a dicarboxylic acid as monomer structural units; the copolymer nylon in which an co-amino-co'-carboxylic acid has been polycondensed is, in other words, a copolymer nylon containing an ω-amino-ω'-carboxylic acid as a monomer structural unit; and the copolymer nylon in which a cyclic lactam has been ring-opened is, in other words, a copolymer nylon containing a cyclic lactam as a monomer structural unit.

Examples of the diamine include ethylenediamine, trimethylenediamine, tetramethylenediamine, pentamethylenediamine, hexamethylenediamine, 1,7-diaminoheptane, 1,8-diaminooctane, 1,9-diaminononane, 1,10-diaminodecane, phenylenediamine, and m-xylylenediamine.

Examples of the dicarboxylic acid include glutaric acid, adipic acid, pimelic acid, suberic acid, azelaic acid, sebacic acid, nonanedicarboxylic acid, decanedicarboxylic acid, tetradecanedicarboxylic acid, octadecanedicarboxylic acid, fumaric acid, phthalic acid, xylylene dicarboxylic acid, and a dimer acid (an unsaturated dicarboxylic acid containing 36 carbon atoms, synthesized from an unsaturated fatty acid including linoleic acid or oleic acid as a main component).

Examples of the co-amino-co'-carboxylic acid include 6-aminocaproic acid, 7-aminoheptanoic acid, 9-aminononanoic acid, 11-aminoundecanoic acid, and 12-aminododecanoic acid.

Examples of the cyclic lactam include ε-caprolactam, ω-enantholactam, and ω-lauryllactam.

The dicarboxylic acid to be used as the polymerization regulator may be the same as the dicarboxylic acid to be used in the production of the copolymer nylon, and examples include glutaric acid, adipic acid, pimelic acid, suberic acid, azelaic acid, sebacic acid, nonanedicarboxylic acid, decanedicarboxylic acid, tetradecanedicarboxylic acid, octadecanedicarboxylic acid, fumaric acid, phthalic acid, xylylene dicarboxylic acid, and a dimer acid. Examples of the monocarboxylic acid include caproic acid, heptanoic acid, nonanoic acid, undecanoic acid, and dodecanoic acid.

Specific examples of the copolymer nylon include nylon 6/66 copolymer, nylon 6/610 copolymer, nylon 6/11 copolymer, nylon 6/12 copolymer, nylon 6/66/11 copolymer, nylon 6/66/12 copolymer, nylon 6/66/11/12 copolymer, and nylon 6/66/610/11/12 copolymer. Among the above, nylon 6/66/11/12 copolymer, nylon 6/66/12 copolymer, and nylon 6/12 copolymer are preferred. As used herein, the slash "/" is used to indicate that the copolymer is a copolymer of each of the nylons. For example, nylon 6/66 copolymer refers to a copolymer nylon of nylon 6 and nylon 66.

When the copolymer nylon is a commercial product, examples of the commercial product include a copolyamide-based resin (trade name "Griltex") manufactured by EMS-CHEMIE, Ltd.; and (trade name "PLATAMID") manufactured by Arkema Inc.

While the volume average particle diameter of the copolymer nylon powder (B) is not specifically limited, it is preferably 1 to 25 µm, more preferably 1.5 to 20 µm, still more preferably 3 to 15 µm, and particularly preferably 5 to 15 µm. When the volume average particle diameter is 25 µm or less, a cured product of the epoxy resin composition can have suitable adhesion. When the volume average particle diameter is 1 µm or more, the epoxy resin composition can have an appropriate viscosity, and the copolymer nylon powder (B) can be suitably dispersed in the epoxy resin composition of the present invention.

The volume average particle diameter of the copolymer nylon powder (B) represents the value determined using the electrical sensing zone method (pore electrical resistance method).

Specific examples of the apparatus for measuring the volume average particle diameter using the pore electrical resistance method include an electrical sensing-type particle size distribution measurement apparatus (trade name "Coulter Multisizer" manufactured by Beckman Coulter, Inc.). There are various sizes for the aperture diameter to be used in the measurement, and each aperture diameter has an analytical range (sizes of volume average particle diameters) suitable for the measurement. The aperture diameter can be selected to cover particle diameters included in the particles to be measured. In the Examples described below, an aperture diameter of 100 µm was used based on this principle. An aperture diameter smaller than 100 µm may be selected to measure particles including particle diameters smaller than the analytical range for which the aperture diameter of 100 µm is suitable; and an aperture diameter greater than 100 µm may be selected to measure particles including particle diameters greater than the analytical range for which the aperture diameter of 100 µm is suitable.

While the melting point of the copolymer nylon powder (B) is not specifically limited, the lower limit of the melting point is preferably 60°C or higher, and particularly preferably 70°C or higher. The upper limit of the melting point is preferably lower than 170°C, more preferably lower than 150°C, and particularly preferably lower than 145°C.

The melting point of the copolymer nylon powder (B) represents the value determined using a differential scanning calorimeter (DSC).

The shape of the copolymer nylon powder (B) is preferably spherical. The fact that the copolymer nylon powder is spherical can be confirmed with an electron microscope, for example. In the present invention, "spherical" may include a sphere that is allowed to have a distortion of about 10% relative to a perfect sphere.

The average degree of circularity of the copolymer nylon powder (B) is preferably 60 to 100, and more preferably 70 to 100.

Regarding the shape of the copolymer nylon powder (B), the average degree of circularity is measured using an image analysis-type particle size distribution measurement apparatus (for example, Microtrac PartAn SI manufactured by MicrotracBEL Corporation). The average degree of circularity represents the value obtained by summing all the values of the degree of circularity of projected images detected in a measurable range of particle diameters, and dividing the sum value by the number of the detected projected images. As used herein, the projected images refers to the images of particles detected (projected) as images by the apparatus. The degree of circularity refers to a representative index (equivalent circle diameter/perimeter diameter) that indicates how close to a circle the projected image is. The equivalent circle diameter refers to the diameter of a circle having the same area as that of the particle projected image. The perimeter diameter refers to the diameter of a circle having the same perimeter as that of the projected image.

To further improve the powder properties, the copolymer nylon powder (B) may be a copolymer nylon powder having improved flowability, which is obtained by adding an inorganic micropowder of silica, alumina, or the like as a lubricant.

The copolymer nylon powder (B) may be a commercial powder, or may be particles emulsified with a surfactant.

In the epoxy resin composition of the present invention, the copolymer nylon powder (B) is preferably contained in an amount of 1 to 50 parts by mass, more preferably 3 to 40 parts by mass, and still more preferably 3 to 30 parts by mass, per 100 parts by mass of the epoxy resin (A), from the viewpoint of obtaining an epoxy resin composition having excellent adhesion to copper and aluminum, and having excellent adhesion in a low-temperature environment.

### <Curing Agent That May Be Contained in Epoxy Resin Composition>

The epoxy resin composition of the present invention may further contain a curing agent, in addition to the epoxy resin (A) and the copolymer nylon powder (B). The curing agent is not specifically limited as long as it can react with the epoxy resin (A) to give a cured product. A single curing agent may be used, or two or more curing agents may be used as a mixture.

Examples of the curing agent include an amine-based curing agent, an amide-based curing agent, an acid anhydride-based curing agent, a phenol-based curing agent, a mercaptan-based curing agent, an isocyanate-based curing agent, an active ester-based curing agent, and a cyanate ester-based curing agent.

Examples of the amine-based curing agent include chain aliphatic amines, such as ethylenediamine, diethylenetriamine, triethylenetetramine, and tetraethylenepentamine; cycloaliphatic amines, such as isophoronediamine, benzenediamine, bis(4-aminocyclohexyl)methane, bis(aminomethyl)cyclohexane, and diaminodicyclohexylmethane; aromatic amines, such as metaphenylenediamine, diaminodiphenylmethane, diethyltoluenediamine, and diaminodiethyldiphenylmethane; and secondary and tertiary amines, such as benzyldimethylamine, triethylenediamine, piperidine, 2-(dimethylaminomethyl)phenol, 2,4,6-tris(dimethylaminomethyl)phenol, DBU (1,8-diazabicyclo(5,4,0)-undecene-7), and DBN (1,5-diazabicyclo(4,3,0)-nonene-5).

Examples of the amide-based curing agent include dicyandiamide and derivatives thereof, and polyamide resins (such as polyaminoamide).

Examples of the acid anhydride-based curing agent include aliphatic acid anhydrides, such as maleic anhydride and dodecenylsuccinic anhydride; aromatic acid anhydrides, such as phthalic anhydride, trimellitic anhydride, and pyromellitic dianhydride; and cycloaliphatic acid anhydrides, such as methylnadic anhydride, tetrahydrophthlic anhydride, methyltetrahydrophthalic anhydride, hexahydrophthalic anhydride, and 4-methylhexahydrophthahic anhydride.

Examples of the phenol-based curing agent include a phenol novolac resin, a cresol novolac resin, a biphenyl-type novolac resin, a triphenylmethane-type phenol resin, a naphthol novolac resin, a phenol biphenylene resin, a phenol aralkyl resin, a biphenylaralkyl-type phenol resin, a modified polyphenylene ether resin, and a compound having a benzoxazine ring.

Examples of the mercaptan-based curing agent include trimethylolpropane tris(3-mercaptopropionate), tris-[(3-mercaptopropionyloxy)-ethyl]-isocyanurate, pentaerythritol tetrakis(3-mercaptopropionate), tetraethyleneglycol bis(3-mercaptopropionate), pentaerythritol tetrakis(3-mercaptobutyrate), 1,4-bis(3-mercaptobutyryloxy)butane, trimethylolpropane tris(3-mercaptobutyrate), trimethylolethane tris(3-mercaptobutyrate), and a polysulfide polymer.

Examples of the isocyanate-based curing agent include hexamethylene diisocyanate, 1,4-tetramethylene diisocyanate, 2-methylpentane-1,5-diisocyanate, lysine diisocyanate, isophorone diisocyanate, and norbornane diisocyanate.

Examples of the active ester-based curing agent include compounds having, per molecule, one or more ester groups reactive with epoxy resins, for example, a phenol ester, a thiophenol ester, an N-hydroxyamine ester, and a heterocyclic hydroxy compound ester.

Examples of the cyanate ester-based curing agent include a novolac-type cyanate resin, and bisphenol-type cyanate resins, such as a bisphenol A-type cyanate resin, a bisphenol E-type cyanate resin, and a tetramethylbisphenol F-type cyanate resin.

The amount of the curing agent to be contained in the epoxy resin composition of the present invention is not specifically limited. For example, the curing agent is preferably contained in an amount such that 0.1 to 5 equivalents of reactive functional groups in the curing agent are present per equivalent of epoxy groups in the entire epoxy resin (epoxy resin (A)). The reactive functional groups in the curing agent are more preferably present in an amount of 0.3 to 3 equivalents, and still more preferably 0.5 to 2 equivalents.

### <Curing Accelerator That May Be Contained in Epoxy Resin Composition>

The epoxy resin composition of the present invention may further contain a curing accelerator, in addition to the epoxy resin (A) and the copolymer nylon powder (B). When the curing accelerator is used in combination with the curing agent, it can increase the curing reaction rate, or increase the strength of the resulting cured product, for example. The curing accelerator can accelerate curing of the epoxy resin, even if it is not used in combination with the curing agent. The curing accelerator is not specifically limited as long as it can react with the epoxy resin to give a cured product. A single curing accelerator may be used, or two or more curing accelerators may be used as a mixture.

Examples of the curing accelerator include imidazole and imidazole compounds, such as 2-methylimidazole, 2-ethylimidazole, 2-ethyl-4-methylimidazole, and 2-phenylimidazole; dicyandiamide and derivatives thereof; tertiary amines, such as DBU (1,8-diazabicyclo(5,4,0)-undecene-7), DBN (1,5-diazabicyclo(4,3,0)-nonene-5), and 2,4,6-tris(dimethylaminomethyl)phenol; a phosphorus-based compound, a Lewis acid compound, and a cationic polymerization initiator.

In the epoxy resin composition of the present invention, at least one curing agent selected from the group consisting of an amine-based curing agent, an acid anhydride-based curing agent, and a phenol-based curing agent may be used, and at least one curing accelerator selected from the group consisting of imidazole, dicyandiamide, a phosphorus-based compound, and a cationic polymerization initiator may be used.

In the epoxy resin composition of the present invention, the amount of the curing accelerator to be contained is not specifically limited. For example, the curing accelerator is preferably contained in an amount of 0.01 to 10 parts by mass per 100 parts by mass of the epoxy resin (A). The curing accelerator is more preferably contained in an amount of 0.1 to 5 parts by mass, and still more preferably 0.5 to 3 parts by mass, per 100 parts by mass of the epoxy resin (A).

### <Additives That May Be Contained in Epoxy Resin Composition>

The epoxy resin composition of the present invention may optionally contain other additives, as long as they do not impair the object or effects of the present invention.

Examples of the additives include antioxidants, inorganic fluorescent substances, lubricants, ultraviolet absorbers, heat/light stabilizers, antistatic agents, polymerization inhibitors, antifoaming agents, solvents, anti-aging agents, radical inhibitors, adhesion-improving agents, flame retardants, surfactants, storage stability-improving agents, ozone aging inhibitors, thickeners, plasticizers, radiation-blocking agents, nucleating agents, coupling agents, conductivity-imparting agents, phosphorus-based peroxide-decomposing agents, pigments, metal deactivators, and physical property-controlling agents.

### <Method for Producing Epoxy Resin Composition>

The epoxy resin composition of the present invention can be produced by mixing the epoxy resin (A), the copolymer nylon powder (B), and optionally a curing agent, a curing accelerator, and other additives.

The mixing method is not specifically limited as long as it can homogeneously mix the components, and examples include mixing and stirring with a paddle blade; mixing and stirring with a homomixer; and mixing and stirring with a planetary centrifugal mixer.

Because the epoxy resin composition of the present invention has a low viscosity, it can be prepared without adding a solvent. Optionally, however, a solvent (such as toluene, xylene, methyl ethyl ketone, acetone, cyclohexanone, methylcyclohexane, or cyclohexane) may be added to the epoxy resin composition, as long as it does not adversely affect the effects of the present invention.

A cured product can be obtained by curing the epoxy resin composition of the present invention. The curing method is not specifically limited; for example, the composition can be cured by heating. The curing temperature is typically from room temperature (25°C) to 250°C. The curing time, which may vary depending on the liquid composition, may be set in a wide range that is typically from 30 minutes to 1 week.

The epoxy resin composition of the present invention can be suitably used for purposes such as an adhesive, a material for a structure, a composite material, a carbon fiber composite material, an adhesive for an electronic material, a semiconductor sealing material, a potting material, a substrate material, a lamination material, a coating material, and a paint. The epoxy resin composition of the present invention can be suitably used as an adhesive suitable for joining an aluminum member or a copper member to another member (such as a member composed of aluminum, copper, iron, stainless steel, or the like).

### <Cured Product of Epoxy Resin Composition>

A cured product of the epoxy resin composition of the present invention is obtained by curing the epoxy resin composition of the present invention described above. While the method for curing the epoxy resin composition of the present invention is not specifically limited, examples include a method in which the epoxy resin composition of the present invention is heated, as described above.

### Examples

The present invention will be hereinafter described in detail by way of examples and comparative examples, although the present invention is not limited thereto. The melting point of each copolymer nylon powder represents the value determined using a differential scanning calorimeter (DSC).

### [Production Example 1 of Copolymer Nylon Powder A]

In a pressure-resistant autoclave with an internal volume of 1 liter, equipped with a turbine-type stirring blade with a diameter of 50 mm, 160 g of a copolyamide (melting point: 90°C, melt viscosity: 150 Pa·s) as a copolymer nylon, 224 g of deionized water, and 16 g of a surfactant were placed, and the autoclave was hermetically sealed. Subsequently, the temperature inside the autoclave was increased to 180°C with stirring. Stirring was further continued while maintaining the inside temperature at 180°C, and then the contents were cooled to room temperature to obtain an aqueous dispersion of the copolymer nylon. Subsequently, the aqueous medium was filtered off from the aqueous dispersion. Subsequently, the wet cake was put in a reduced-pressure dryer and dried under reduced pressure, and then removed to obtain a copolymer nylon powder A. The copolymer nylon powder A thus obtained exhibited a volume average particle diameter of 14.5 µm, as measured by the electrical sensing zone method using the aperture 100. A portion of the copolymer nylon powder A was extracted and observed with a scanning electron microscope (JSM-6390LA manufactured by JEOL). This confirmed that the copolymer nylon powder A was spherical in shape. Moreover, the average degree of circularity of the copolymer nylon powder A was measured using an image analysis-type particle size distribution measurement apparatus (Microtrac PartAn SI manufactured by MicrotracBEL Corporation). As a result, the average degree of circularity of the copolymer nylon powder A was measured as 90.

### [Production Example 2 of Copolymer Nylon Powder B]

A copolymer nylon powder B was obtained as in Production Example 1, except that the copolyamide used in Production Example 1 was replaced with a copolyamide (melting point: 120°C, melt viscosity: 600 Pa·s). The powder thus obtained exhibited a volume average particle diameter of 10.5 µm, as measured by the electrical sensing zone method using the aperture 100. A portion of the powder was extracted and observed with a scanning electron microscope (JSM-6390LA manufactured by JEOL). This confirmed that the powder was spherical in shape. Moreover, the average degree of circularity of the copolymer nylon powder B was measured using an image analysis-type particle size distribution measurement apparatus (Microtrac PartAn SI manufactured by MicrotracBEL Corporation). As a result, the average degree of circularity of the copolymer nylon powder B was measured as 98.

### [Production Example 3 of Copolymer Nylon Powder C]

A copolymer nylon powder C was obtained as in Production Example 1, except that the copolyamide used in Production Example 1 was replaced with a copolyamide (melting point: 130°C, melt viscosity: 1,000 Pa·s). The powder thus obtained exhibited a volume average particle diameter of 12.5 µm, as measured by the electrical sensing zone method using the aperture 100. A portion of the powder was extracted and observed with a scanning electron microscope (JSM-6390LA manufactured by JEOL). This confirmed that the powder was spherical in shape. Moreover, the average degree of circularity of the copolymer nylon powder C was measured using an image analysis-type particle size distribution measurement apparatus (Microtrac PartAn SI manufactured by MicrotracBEL Corporation). As a result, the average degree of circularity of the copolymer nylon powder C was measured as 98.

### Examples 1 to 4 and Comparative Examples 1 to 3

### [Production of Epoxy Resin Compositions]

Each of the epoxy resin compositions was produced by homogeneously mixing the components in the amounts (mass ratio) shown in Table 1, and then thoroughly degassing the mixture.

The components shown in Table 1 are as follows:
- Epoxy resin: Bis-A-type epoxy resin (JER grade 828, manufactured by Mitsubishi Chemical Corporation)
- Copolymer nylon powder A: the powder produced in Production Example 1 of the copolymer nylon powder above
- Copolymer nylon powder B: the powder produced in Production Example 2 of the copolymer nylon powder above
- Copolymer nylon powder C: the powder produced in Production Example 3 of the copolymer nylon powder above
- Polyamide powder: 12 nylon particles (SP-10 manufactured by Toray, Industries, Inc.)
- Synthetic rubber: Hypro CTBN 1300X8 (manufactured by PTI Japan Ltd.)
- Curing accelerator: 2-ethyl-4-methylimidazole (CUREZOL 2E4MZ manufactured by Shikoku Chemicals Corporation)

### [Evaluation of Properties]

### (1) Tensile Shear Adhesion Strength to Aluminum Sheet

Each of the epoxy resin compositions obtained in Examples 1 to 4 and Comparative Examples 1 to 3 was applied to an aluminum sheet (JIS A1050P) (size: 2 × 25 × 100 mm) such that the adhesive portion became a 12.5 × 25 mm rectangle, and this aluminum sheet was bonded to another aluminum sheet. The resulting material was heated at 80°C for 1 hour, at 100°C for 1 hour, and at 150°C for 2 hours to cure the epoxy resin composition, thereby preparing a test sample for measuring the tensile shear adhesion strength. The aluminum sheet surface was cleaned with acetone and dried to prepare the test sample for measuring the tensile shear adhesion strength.

A tensile shear adhesion test was performed on the adhesion test sample, using a tensile testing machine (AGS-X manufactured by Shimadzu Corporation) at a grip distance of 100 mm and a test speed of 5 mm/min. Based on the adhesive area and the measurement value of the maximum strength at break, the tensile shear adhesion strength to the aluminum sheet was calculated. The results are shown in Table 1.

### (2) Peel Strength on Copper Foil

Copper foil was cut into a size of 5 cm or more × 5 cm or more, and the preservative was cleaned off with acetone. The copper foil was then etched with 10% nitric acid for 30 seconds and washed with distilled water, and then dried at 60°C to prepare a test sample. Each of the epoxy resin compositions obtained in Examples 1 to 4 and Comparative Examples 1 to 3 was applied to an aluminum sheet, and the copper foil was placed over the aluminum sheet. The resulting material was heated at 80°C for 1 hour, at 100°C for 1 hour, and at 150°C for 2 hours to cure the epoxy resin composition, and then cut into a width of 1 cm with a cutter to prepare a test sample for measuring the peel strength on the copper foil.

Subsequently, a 90 degree peel strength was measured for the test sample for measuring the peel strength, using a tensile testing machine (AGS-X manufactured by Shimadzu Corporation) at a test speed of 50 mm/min. The results are shown in Table 1.

### (3) Adhesion in Low-Temperature Environment

Each of the epoxy resin compositions obtained in Examples 1 to 4 and Comparative Examples 1 to 3 was applied to aluminum foil in an environment at 25°C, and the resulting material was heat-sealed at 2 kgf/cm² for 10 minutes such that the adhesive portion became a 25 × 120 mm rectangle. A test sample A and a test sample B were prepared by setting the heat-seal temperature to 100°C and 80°C, respectively. Each of the test samples A and B was peeled in the 180° direction at 50 mm/min in an environment at 25°C, and low-temperature peel strengths A and B (N/cm) were measured. The results are shown in Table 1.

**[Table 1]**

| | Example 1 | Example 2 | Example 3 | Example 4 | Comparative Example 1 | Comparative Example 2 | Comparative Example 3 |
|---|---|---|---|---|---|---|---|
| Epoxy Resin (part(s) by mass) | 100 | 100 | 100 | 100 | 100 | 100 | 100 |
| Copolymer Nylon Powder A (part(s) by mass) | 5 | 30 | - | - | - | - | - |
| Copolymer Nylon Powder B (part(s) by mass) | - | - | 5 | - | - | - | - |
| Copolymer Nylon Powder C (part(s) by mass) | - | - | - | 30 | - | - | - |
| Polyamide Powder (part(s) by mass) | - | - | - | - | - | 5 | - |
| Synthetic Rubber (part(s) by mass) | - | - | - | - | - | - | 5 |
| Curing Accelerator (part(s) by mass) | 3 | 3 | 3 | 3 | 3 | 3 | 3 |
| Tensile Shear Adhesion Strength (MPa) to Aluminum Sheet | 10 | 12 | 10 | 12 | 4 | 5 | 3 |
| Peel Strength (N/cm) on Copper Foil | 10 | 11 | 10 | 10 | 6 | 6 | 4 |
| Low-Temperature Peel Strength A (N/cm) (Heat-Seal Temperature for Test Sample: 100°C) | 0.95 | 1.18 | 0.84 | 0.75 | 0.33 | 0.41 | 0.38 |
| Low-Temperature Peel Strength B (N/cm) (Heat-Seal Temperature for Test Sample: 80°C) | 0.72 | 1.07 | 0.71 | 0.54 | 0.26 | 0.31 | 0.32 |

## Claims

1. An epoxy resin composition comprising (A) an epoxy resin and (B) a copolymer nylon powder.

2. The epoxy resin composition according to claim 1, wherein the copolymer nylon powder (B) is spherical.

3. The epoxy resin composition according to claim 1 or 2, wherein the copolymer nylon powder (B) is contained in an amount of 1 to 50 parts by mass per 100 parts by mass of the epoxy resin (A).

4. The epoxy resin composition according to any one of claims 1 to 3, wherein the copolymer nylon powder (B) is at least one selected from the group consisting of nylon 6/66 copolymer, nylon 6/610 copolymer, nylon 6/11 copolymer, nylon 6/12 copolymer, nylon 6/66/11 copolymer, nylon 6/66/12 copolymer, nylon 6/66/11/12 copolymer, and nylon 6/66/610/11/12 copolymer.

5. The epoxy resin composition according to any one of claims 1 to 4, wherein the epoxy resin composition is used for any purpose from an adhesive, a material for a structure, a composite material, a carbon fiber composite material, an adhesive for an electronic material, a semiconductor sealing material, a potting material, a substrate material, a lamination material, a coating material, and a paint.

6. The epoxy resin composition according to any one of claims 1 to 5, wherein the copolymer nylon powder (B) has a volume average particle diameter of 1 to 25 µm.

7. A cured product of the epoxy resin composition according to any one of claims 1 to 6.
